**Europäisches Patentamt**

**European Patent Office**

**Office européen des brevets**

(19)

(11) Publication number: **0 203 895**
**A2**

(12) # EUROPEAN PATENT APPLICATION

(21) Application number: **86830134.2**

(22) Date of filing: **21.05.86**

(51) Int. Cl.⁴: **H 03 D 7/12**

(30) Priority: **24.05.85 IT 2089785**

(43) Date of publication of application: **03.12.86**
**Bulletin 86/49**

(84) Designated Contracting States: **BE DE FR GB IT SE**

(71) Applicant: **INDUSTRIE FACE STANDARD S.p.A., Viale Luigi Bodio, 33, I-20158 Milano (IT)**

(72) Inventor: **Selvazzo, Gianfranco, Via Mastrigli 15-B, Roma (IT)**

(54) **Signal mixer for microwave radio systems.**

(57) A signal mixer for microwave radio systems is proposed, consisting mainly of a single gate field effect transistor (2) (SG FET) provided with a self-bias circuit (4 to 10) powered from a local oscillator (3) with which the mixer is connected.

The proposed active transistor mixer affords a high conversion gain with a low noise figure and a minimal amount of circuitry.

The gist of the solution consists in injecting the signal produced by the local oscillator (3) into the drain D of the SG FET transistor (2).

This will eliminate both the supply voltage at said drain and the related noise contribution.

At the same time the local oscillator (3) will also supply all the bias voltages needed for the operation of the transistor (2).

"SIGNAL MIXER FOR MICROWAVE RADIO SYSTEMS"

The present invention belongs to the technical ground or satellite communication radio link field and relates to a signal mixer for microwave radio systems consisting essentially of a single gate field effect transistor (SG FET) provided with a self-bias circuit powered by a local oscillator with which the mixer is connected.

For a better understanding of the concept and of its structural implementation, a detailed definition of the mixer is provided hereunder.

The mixer is a circuitry module which may also be constructed as a separate component and which is used in radio equipment used for ground and satellite communication. If constructed as a separate component, it may be subsequently mounted onto the radio circuit to which it belongs.

Essentially, a mixer may be classed into two main units, each of which also characterizes the functions it performs:

a) downward frequency converter which converts an incoming radio-frequency signal into a lower-frequency signal, at which level the information carried by the signal may be more easily processed;

b) upwards frequency converter which adapts this low-frequency signal to the normal radio receiver units which operate with radio-frequency signals.

The downward frequency converter mixer is allocated to the receiving antenna unit at whose input the radio-frequency signal is received and suitably amplified and converted so as to be more easily processed at a later stage.

The upward frequency converter mixer is allocated to the transmitter unit in which the intermediate-frequency signal containing the information to be transmitted must be converted into the transmission radio-frequency before it is sent to the transmitting antenna.

The frequency conversion of the intermediate-frequency signal is effected by a suitable mixer.

This mixer carries out said frequency conversion by using a non-linear device in which the signal to be converted interacts with the signal generated by a local oscillator thus producing output signals having the frequency $F_o$ of the local oscillator and of its harmonics, the frequency $F_s$ of the signal itself and of its harmonics and the beat frequencies $MF_s \overline{+} NF_o$, where M and N are integers. A suitable filtering allows to select the output signal, thus putting into effect either a downward frequency conversion $F_o - F_s$ or an upward frequency conversion $F_o + F_s$.

Mixers may be divided into passive mixers and active mixers, according to whether they use passive nonlinear devices (diodes) or active ones (bipolar junction transistors BST or field-effect transistors FET).

Passive mixers supply output signals which are inferior to the input signals.

On the other hand, the construction of passive mixers is easy and economical since they consist of simple components.

In the present state of the technique, diode mixers for radio equipment use Schottky junction diodes which, viewing the unsuitable nonlinearity in their characteristic origin, require the use of a local oscillator power that is considerably higher than the input signal power or else the use of a self-bias circuit with one or two direct input voltages in order to suitably position the diode operating point.

In the present state of the technique, transistor mixers for radio equipment use special transistors for the microwave application with a power supply circuit with one or two direct input voltages, capable of ensuring a stable operating point.

The choice of either one or the other type of mixer depends on the operating features of the system in which it will have to be employed.

Generally, the use of the active mixer is preferred in spite of its higher cost, because the passive mixer features a very low conversion gain and a high output noise level.

The active mixer, on the other hand, features a signal power at the output frequency level which is higher than the signal power at the input frequency level, as well as a lower output noise level.

In order to explain this phenomenon, following considerations must be made.

The frequency conversion of the amplified signal at the mixer input can only be carried out if the mixer is provided with a local signal whose frequency is equal to the sum of the signal carrier frequency for the signal to be received and the signal carrier frequency after the frequency conversion.

This local signal is generated by a local oscillator. The mixer and local oscillator assembly forms the frequency conversion unit or the frequency converter. At the output of this converter there must be only one intermediate-frequency signal. Undesired signals having a non-negligible amplitude may interact with the local oscillator signal and generate frequencies which fall within the intermediate-frequency band of the converter output filters. The purpose of these filters is that of minimizing the amplitude of the frequency conversion spurious products, i.e. the harmonics and combinations of harmonics.

As already mentioned, the passive mixer has the disadvantage of being a low conversion-gain frequency converter featuring therefore a considerable noise factor.

This noise factor is a mixer parameter which defines the mixer in as far as its output noise level is concerned, said noise level being due to the physical operation of the mixer to which must be added the noise of the power supply and of the local oscillator.

To cut down these noise contributions, self-bias circuits are presently used, having one or two direct supply voltages whose values depend on the local oscillator power level.

The object of the invention is therefore that of eliminating above drawbacks and of optimizing existing solutions by providing an active transistor mixer capable of affording a high conversion gain with a low noise figure and a minimal amount of circuitry.

Direct supply voltages are advantageously eliminated from such a mixer in order to minimize related noise contributions.

This object, as well as other objects resulting from the following description, are attained by an active signal mixer for microwave radio systems characterized in that it includes a single gate field-effect transistor (SG FET) connected with a local oscillator which also supplies all the bias voltages required for its operation.

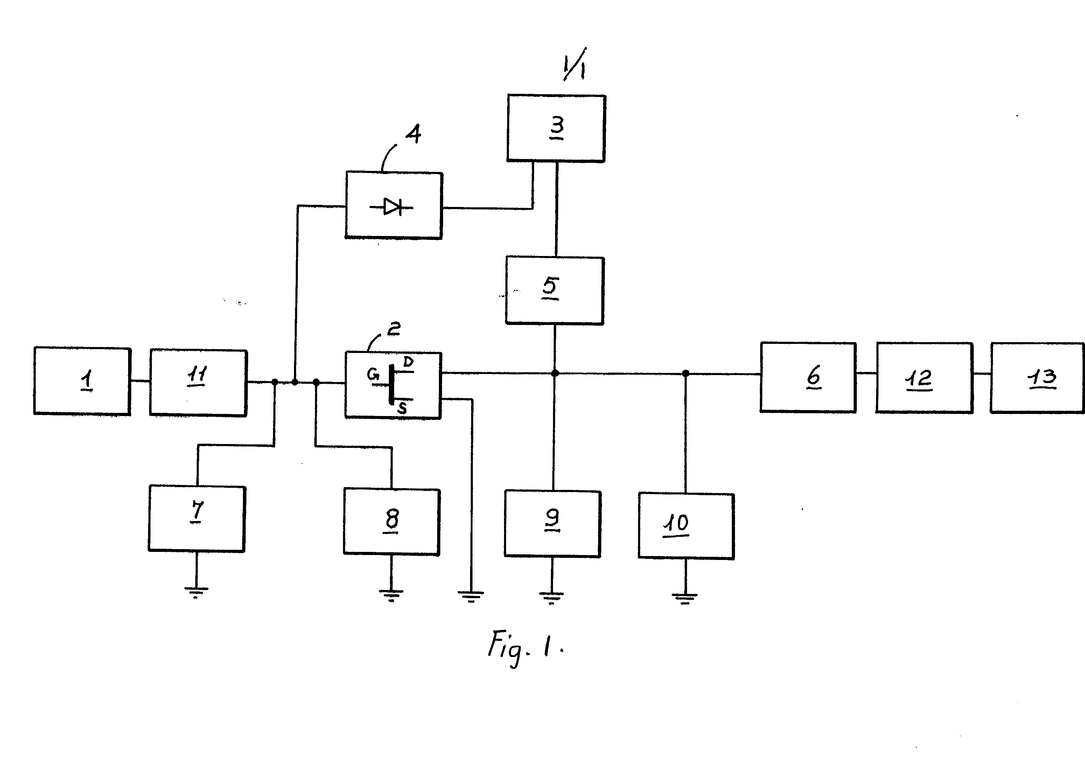

Further purposes and advantages of the invention will be emphasized by the following detailed description, illustrated by way of an example only in the enclosed drawing showing a block diagram of the mixer according to the present invention.

In the enclosed drawing, the reference number 1 has been used to indicate the input signal having frequency $F_s$, 2 indicates an SG FET transistor, 3 indicates a local oscillator from which a fraction of a signal is taken through a coupling-levelling circuit 4, 5 indicates a high-pass filter, 6 is a low-pass filter and 7, 8, 9 and 10 indicate special trap filters parallel-connected along the signal path.

Reference numbers 11 and 12 are used to indicate input and output matching circuits series-connected along the signal path, said signal assuming at the output marked 13 a frequency $F_o-F_s$, called intermediate frequency.

After having listed mainly from a structural viewpoint the components making up the present invention, there follows a description of its operation.

To begin with, it should be specified that the principle on which the invention is based consists in injecting the signal produced by the local oscillator 3 into the drain D of the SG FET transistor 2.

This will eliminate both the supply voltage at said drain and the related noise contribution.

At the same time the local oscillator 3 will also supply

- 5 -

0203895

all the bias voltages needed for the operation of the transistor 2.

The input signal 1 with frequency $F_s$ is injected in the gate G of the SG FET transistor 2 whose source S is grounded, according to the present invention. This type of connection minimizes the transistor 2 source inductance whereby the advantage of improving the performance of said SG FET transistor 2 also at higher frequency levels is obtained.

In addition, a small fraction of the signal generated by the local oscillator 3 is input in gate G of the SG FET 2. This fraction is withdrawn through a coupling and levelling circuit 4 which suitably keys said signal by rectifying and levelling it.

By withdrawing this signal fraction from the local oscillator 3 a bias voltage is obtained which, by itself, is capable of raising gate G of SG FET 2 to a potential which is slightly more negative than that of the drain D of the same SG FET 2.

This provides a further advantage of the mixer according to the invention, since it affords the possibility of attaining a considerable circuit simplification viewing that the local oscillator 3 will supply all the bias voltages required for the operation of transistor 2.

Finally, a better frequency conversion quality will also be obtained.

The input signal 1 with frequency $F_s$ is suitably mixed with the signal from the local oscillator 3.

In fact, the signal from the local oscillator 3 is injected in drain D of SG FET 2, where the output signal 13 having the intermediate frequency $F_o - F_s$ is simultaneously picked up.

Both the signal from the local oscillator 3 and the output signal 13 pass through the filtering networks represented by filter 5 and filter 6 respectively. The purpose of these two filters is to further attenuate the spurious frequencies which are always present.

The trap filters 7, 8, 9 and 10 represent a further filtering network for the frequencies of the output signal 13, of the local oscillator 3, of the input signal 1 and all the intermodulation products (spurious frequencies, harmonics, others) present along the entire signal path.

Each of the above mentioned filters consists of special compensation circuits, called stubs, which behave like quarter-wave or quarter-wave multiple resonant circuits connected in parallel with the line representing the signal path, both ahead of and behind the SG FET 2.

The purpose of the matching circuits 11 and 12 is to match the impedance of the input and output of the circuit under review.

The local oscillator 3 operates at 10750 MHz in a very wide stability range.

The invention thus attains its objects.

In fact, the mixer according to the invention provides a considerable circuit simplification as far as the power supply is concerned and a better frequency conversion quality because of the high gain that may be obtained.

It is obvious that the use of components and means of conversion even if different from those illustrated above but which are used for the same purposes, falls within the scope of the invention.

Thus, for instance, instead of the SG FET 2 transistor, a double-gate field-effect transistor (DG FET) may be used, which offers the advantage of injecting separately the signals to be mixed into the two gates.

In addition, this DG FET may also be used as an amplitude modulator AM when one of its two gates is being used to control the output signal amplitude modulation.

0203895

PATENT CLAIMS

1)      Signal  mixer  for  microwave  radio  systems,  characterized  in that  it  comprises  an  SG  FET  transistor  connected  with  a  local  oscillator  from  which  it  takes  all  the  bias  voltages  required  for  its operation.

2)      Signal  mixer  for  microwave  radio  systems  as  claimed  in  claim 1,  characterized  in  that  said  local  oscillator  injects  its  own signal  into  the  drain  D  of  said  SG  FET  transistor.

3)      Signal  mixer  for  microwave  radio  systems  as  claimed  in  claims 1  and  2,  characterized  in  that  the  intermediate-frequency  output signal  is  also  withdrawn  from  said  drain  D  of  said  SG  FET  transistor.

4)      Signal  mixer  for  microwave  radio  systems  as  claimed  in  claim 1,  characterized  in  that  the  required  bias  voltage  is  applied  to gate  G  of  said  SG  FET  by  withdrawing  a  small  fraction  of  the  local oscillator  signal  through  a  suitable  coupling-levelling  circuit.

5)      Signal  mixer  for  microwave  radio  systems  as  claimed  in  claim, 1,  characterized  in  that  the  source  S  of  said  SG  FET  transistor is  directly  grounded.

6)      Signal  mixer  for  microwave  radio  systems  as  claimed  in  claim 1,  characterized  in  that  as  an  alternative  to  said  SG  FET  transistor, a  DG  FET  transistor  may  be  used.

7)      Signal  mixer  for  microwave  radio  systems  as  claimed  in  claim 6,  characterized  in  that  said  DG  FET  may  be  used  as  an  amplitude modulator  AM.

8)      Signal  mixer  for  microwave  radio  systems  as  claimed  in  the previous  claims  and  as  described  and  illustrated  in  the  foregoing, to  be  used  for  the  purposes  specified  herein.

XXXXXXXXXXXXXXXXXXXX

Fig. 1.

0203895